# EUROPÄISCHE PATENTSCHRIFT

(11) **EP 1 010 238 B1**
(45) Veröffentlichungstag und Bekanntmachung des Hinweises auf die Patenterteilung: **04.07.2001**
(21) Anmeldenummer: 98947395.4
(22) Anmeldetag: 14.08.1998
(51) Int. Cl.: H03F 1/30

(54) **VERSTÄRKERSCHALTUNG**
AMPLIFIER CIRCUIT
CIRCUIT AMPLIFICATEUR

(30) Priorität: 05.09.1997 DE 19738940
(43) Veröffentlichungstag der Anmeldung: 21.06.2000
(73) Patentinhaber: Infineon Technologies AG, 81669 München (DE)
(72) Erfinder: LOHNINGER, Gerhard, D-81549 München (DE)
(74) Vertreter: Zedlitz, Peter, Dipl.-Inf.
(86) Internationale Anmeldenummer: DE9802366
(87) Internationale Veröffentlichungsnummer: WO9913569

(56) Entgegenhaltungen:
- US-A- 3 493 882
- BARANOV A V ET AL: "INVESTIGATION OF THE TEMPERATURE STABILITY OF A BROADBAND MICROWAVEAMPLIFIER-LIMITER*" TELECOMMUNICATIONS AND RADIO ENGINEERING, Bd. 43, Nr. 7, 1. Juli 1988, Seiten 148-150, XP000119010
- PATENT ABSTRACTS OF JAPAN vol. 001, no. 126 (E-056), 20. Oktober 1977 & JP 52 060047 A (NIPPON TELEGR & TELEPH CORP), 29. Juni 1977

## Beschreibung

Die Erfindung betrifft eine Verstärkerschaltung mit einem ersten Transistor vom einen Leitungstyp, in dessen Steuerleitung ein Eingangssignal eingekoppelt ist und dessen gesteuerte Strecke an einem Ende mit einem ersten Versorgungspotential verbunden ist, einen zweiten Transistor vom einen Leitungstyp, an dessen Steuerleitung ein Bias-Potential angelegt ist und dessen gesteuerte Strecke an einem Ende mit dem anderen Ende der gesteuerten Strecke des ersten Transistors verbunden ist und an dem anderen Ende ein Ausgangssignal abgibt, und einem ersten Widerstand, der zwischen das andere Ende des zweiten Transistors und das zweite Versorgungspotential geschaltet ist.

Eine derartige Verstärkerschaltung wird allgemein als Kaskode-Verstärkerschaltung bezeichnet und ist beispielsweise aus U. Tietze, Ch. Schenk, "Electronic Circuits", 1991, Seiten 439 und 440 bekannt. Kaskode-Verstärkerschaltungen zeichnen sich durch einen hohen Eingangswiderstand sowie durch die Elimination des Miller-Effekts aus. Sie sind jedoch empfindlich gegenüber Bauteilparameterschwankungen, Temperaturschwankungen und Spannungsschwankungen.

Aufgabe der Erfindung ist es, die bekannte Kaskode-Verstärkerschaltung derart weiterzubilden, daß Bauteileparameterschwankungen, Temperaturschwankungen und Spannungsschwankungen einen geringeren Einfluß ausüben.

Die Erfindung wird durch eine Verstärkerschaltung gemäß Patentanspruch 1 gelöst. Ausgestaltungen und Weiterbildungen des Erfindungsgedankens sind Gegenstand von Unteransprüchen.

Die erfindungsgemäße Verstärkerschaltung umfaßt eine Kaskode-Stufe mit einem ersten Transistor vom einen Leitungstyp, in dessen Steuerleitung ein Eingangssignal eingekoppelt ist und dessen gesteuerte Strecke an einem Ende mit einem ersten Versorgungspotential verbunden ist, einem zweiten Transistor vom einen Leitungstyp, an dessen Steuerleitung ein Bias-Potential angelegt ist und dessen gesteuerte Strecke an einem Ende mit dem anderen Ende der gesteuerten Strecke des ersten Transistors verbunden ist und an dem anderen Ende ein Ausgangssignal gibt, und einem ersten Widerstand, der zwischen das andere Ende des zweiten Transistors und das zweite Versorgungspotential geschaltet ist. Weiterhin umfaßt die Verstärkerschaltung erfindungsgemäß eine erste Kapazität, die der Steuerleitung des ersten Transistors vorgeschaltet ist, einen dritten Transistor vom anderen Leitungstpy, dessen Steuerleitung an dem anderen Ende der gesteuerten Strecke des zweiten Transistors und dessen gesteuerte Strecke an einem Ende mit dem zweiten Versorgungspotential verbunden ist, einen vierten Transistor vom anderen Leitungstyp, dessen Steuerleitung mit dem anderen Ende der gesteuerten Strecke des dritten Transistors verbunden ist und dessen gesteuerte Strecke an einem Ende mit der Steuerleitung des dritten Transistors verbunden ist, einen zweiten Widerstand, der zwischen die Steuerleitung des vierten Transistors und einem Anschluß der ersten Kapazität geschaltet ist, und einen dritten Widerstand, der zwischen das andere Ende der gesteuerten Strecke des vierten Transistors und dem anderen Anschluß der ersten Kapazität geschaltet ist.

Der dritte und vierte Transistor bilden zusammen mit zweitem und drittem Widerstand eine Stabilisierungsstufe zur Regelung des Arbeitspunktes der Kaskode-Stufe. Dabei wird die Spannung im Eingangskreis des dritten Transistors, also die Spannung über dem ersten Widerstand, als Eingangsgröße verwendet, wobei durch die Stabilisierungsschaltung der Strom durch den ersten Widerstand geregelt wird. Auf diese Weise werden Schwankungen bei den Bauteileparametern, bei der Temperatur und bei der Versorgungsspannung ausgeregelt.

Bevorzugt werden dabei die Steuerleitung des vierten Transistors über eine zweite Kapazität mit dem ersten Versorgungspotential und/oder das andere Ende der gesteuerten Strecke des vierten Transistors über eine dritte Kapazität mit dem ersten Versorgungspotential gekoppelt. Zweite und dritte Kapazität dienen dazu, insbesondere hochfrequente Wechselsignale abzublocken.

Bevorzugt wird das Bias-Potential für die Steuerleitung des zweiten Transistors mittels eines zwischen die Steuerleitung und das andere Ende der gesteuerten Strecke des zweiten Transistors geschalteten vierten Widerstands erzeugt. Zur Unterdrückung hochfrequenter Wechselanteile kann dabei eine vierte Kapazität zwischen die Steuerleitung des zweiten Transistors und das erste Versorgungspotential geschaltet werden.

Aufgrund der Stabilisierungsstufe kann der Arbeitsbereich der erfindungsgemäßen Verstärkerschaltung in beliebiger Weise verändert werden. Zum einen ist es möglich, die gesamte Verstärkerschältung auf einfache Weise aus- und einzuschalten. Dazu wird lediglich an den Knotenpunkt zwischen zweitem Widerstand und erster Kapazität über einen fünften Widerstand das erste oder zweite Versorgungspotential angelegt. Wird das zweite Versorgungspotential angelegt, so wird die Stabiliesierungsschaltung deaktiviert und über die Stabilisierungsstufe die Kaskode-Stufe stromlos geschaltet. Die gesamte Verstärkerschaltung ist damit abgeschaltet. Bei Anlegen des ersten Versorgungspotential arbeitet die Stabilisierungsschaltung normal. Der fünfte Widerstand dient dabei zur Entkopplung der hochfrequenten Signale am Eingang E und wird bevorzugt hochohmig ausgeführt.

Neben dem Ein- und Ausschalten läßt sich aber auch der Arbeitspunkt beliebig verschieben. Dies erfolgt durch Ändern des Widerstandswertes des ersten Widerstands. Bevorzugt wird zur Änderung des Widerstandswertes ein sechster Widerstand über einen gesteuerten Schalter dem ersten Widerstand parallel geschaltet. Demzufolge kann entsprechend zwischen zwei Arbeitspunkten umgeschaltet werden. Die Arbeitspunkte können dabei so definiert werden, daß bei parallelgeschalteten Widerständen die Verstärkerschaltung im Normalbetrieb arbeitet und bei Verwendung nur eines Widerstands ein Ruhezustand mit einem gegebenen Ruhestrom eingehalten wird.

Die erfindungsgemäße Verstärkerschaltung ist insbesondere für Hochfrequenzanwendungen geeignet. Dabei werden bevorzugt Transistoren vom Bipolartyp verwendet. In diesem Fall werden das eine Ende der jeweiligen gesteuerten Strecke durch den Emitter, das andere Ende der jeweiligen gesteuerten Strecke durch den Kollektor und die Steuerleitung durch die Basis des entsprechenden Bipolartransistors gebildet.

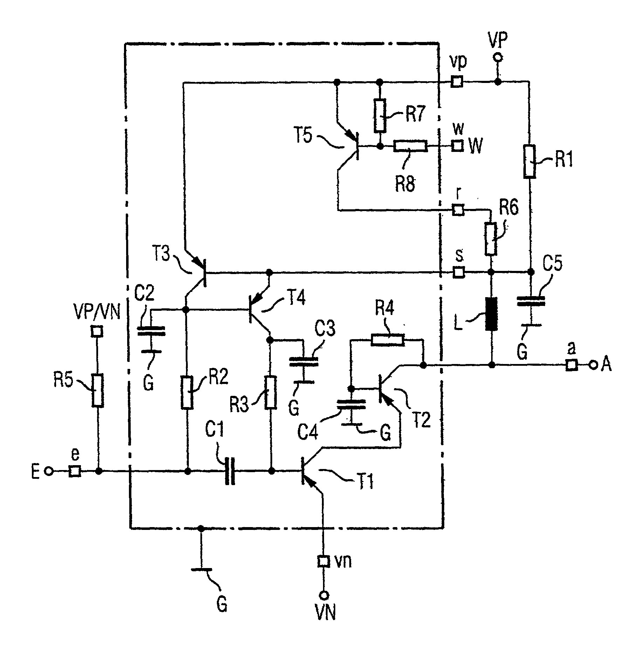

Die Erfindung wird nachfolgend anhand des in der einzigen Figur der Zeichnung dargestellten Ausführungsbeispiels näher erläutert.

Die als Ausführungsbeispiel gezeigte erfindungsgemäße Verstärkerschaltung enthält eine Kaskode-Stufe mit einem Bipolartransistor T1 vom npn-Typ, dessen Emitter mit einem Anschluß vn verbunden ist. An den Anschluß vn ist ein negatives Versorgungspotential VN angelegt. An den Kollektor des Transistors T1 ist der Emitter eines Bipolartransistors T2 vom npn-Typ angeschlossen, dessen Kollektor zum einen mit einem Ausgangsanschluß a und zum anderen über einen Widerstand R4 mit seiner eigenen Basis verbunden ist. Seine Basis ist darüber hinaus über eine Kapazität C4 mit Masse G verschaltet. Das negative Versorgungspotential VN liegt dabei an Masse G. Der Widerstand 4 erzeugt dabei an der Basis des Transistors T2 ein Bias-Potential, wobei mittels der Kapazität C4 an der Basis des Transistors T2 auftretende hochfrequente Wechselanteile kurzgeschlossen werden. Der Ausgangsanschluß a, an dem ein Ausgangssignal A abgreifbar ist, ist über eine Induktivität L mit einem Steueranschluß s verbunden, der zudem über einen Widerstand R1 mit einem Versorgungsanschluß vp und über eine Kapazität C5 gekoppelt ist. Der Widerstand R1 dient dabei zur Arbeitspunkteinstellung der Kaskode-Stufe und die Kapazität C5 schließt hochfrequente Wechselanteile kurz. Die Induktivität L und die Kapazität C5 bilden folglich ein Tiefpaßfilter, das die hochfrequenten Anteile im Ausgangssignal A unterdrückt und am Steueranschluß s nur niederfrequente Signalanteile zur Arbeitspunkteinstellung bereitstellt.

Zur Stabilisierung des jeweiligen Arbeitspunktes ist eine Stabilisierungsstufe vorgesehen, die einen Bipolartransistor T3 und einen Bipolartransistor T4 jeweils vom pnp-Typ sowie zwei Widerstände R2 und R3 aufweist. Der Transistor T3 ist dabei emitterseitig mit dem Versorgungsanschluß vp und basisseitig mit dem Steueranschluß s verbunden. Beim Transistor T4 ist der Emitter mit der Basis des Transistors T3 und die Basis mit dem Kollektor des Transistors T3 verbunden. Der Kollektor des Transistors T4 ist dabei zum einen über eine Kapazität C3 mit Masse G und über einen Widerstand R3 mit der Basis des Transistors T1 gekoppelt. Die Basis des Transistors T1 ist darüber hinaus über eine Kapazität C1 an einen Eingangsanschluß e angeschlossen. Der Kollektor des Transistors T3 ist schließlich über eine Kapazität C2 mit Masse G und über einen Widerstand R2 mit dem Eingangsanschluß e gekoppelt. Die Steuerung der Stabilisierungsstufe erfolgt dabei mit der über den Widerstand R1 abfallenden Spannung. Über die Transistoren T3 und T4 wird dabei der Kollektorstrom durch die Transistoren T1 und T2 und damit der Strom durch den Widerstand R1 ausgeregelt und stabilisiert.

Aufgrund der Kapazität C1 gelangen nur Wechselanteile an die Basis des Transistors T1. Wird nun beispielsweise über einen Widerstand R5 das positive Versorgungspotential VP an den Eingangsanschluß e gelegt, so wird das Basispotential des Transistors T4 auf ungefähr dessen Emitterpotential angehoben, so daß dieser sperrt. Die Stabilisierungsstufe ist damit außer Kraft gesetzt. Beim Anlegen des negativen Versorgungspotential VN wird die Stabilisierungsstufe in normaler Weise betrieben.

Da der Arbeitspunkt vom Widerstandswert zwischen dem Versorgungsanschluß vp und dem Steueranschluß s abhängt, kann durch Ändern des Widerstands R1 bzw. durch Parallel- oder Serienschalten weiterer Widerstände dieser Widerstandswert verändert werden. Beim vorliegenden Ausführungsbeispiel erfolgt die Widerstandsänderung durch Parallelschalten eines weiteren Widerstands R6 mittels eines steuerbaren Schalters. Als Schalter findet ein Bipolartransistor T5 vom pnp-Typ Verwendung, dessen Emitter mit dem Versorgungsanschluß VP und dessen Kollektor mit einem Anschluß r verbunden ist. Zwischen den Anschluß r und den Steueranschluß s ist ein Widerstand R6 geschaltet. Die Ansteuerung des Transistors T5 erfolgt derart, daß ein entsprechendes Steuersignal W an einen Anschluß w eingespeist wird, wobei der Anschluß w über einen Widerstand R8 mit der Basis des Transistors T5 gekoppelt ist. Die Basis des Transistors T5 ist darüber hinaus zu Stabilitätszwecken über einen Widerstand R7 mit dem Versorgungsanschluß vp verschaltet. Liegt am Anschluß w ein Potential an, das im wesentlichen gleich dem positiven Versorgungspotential VP ist, dann sperrt der Transistor T5 und der Widerstandswert zwischen dem Versorgungsanschluß vp und dem Steueranschluß s wird im wesentlichen durch den Widerstand R1 bestimmt. Ist jedoch das Signal W gleich dem negativen Versorgungspotential VN, dann schaltet der Transistor T durch und der den Arbeitspunkt bestimmende Widerstandswert ergibt sich aus der Parallelschaltung der Widerstände R1 und R6. Damit lassen sich unabhängig voneinander zwei Arbeitspunkte sowie ein Ein/Aus-Zustand einstellen.

## Patentansprüche

1. Verstärkerschaltung mit
einem ersten Transistor (T1) vom einen Leitungstyp, in dessen Steuerleitung ein Eingangssignal (E) eingekoppelt ist und dessen gesteuerte Strecke an einem Ende mit einem ersten Versorgungspotential (VN) verbunden ist,
einem zweiten Transistor (T2) vom einen Leitungstyp, an dessen Steuerleitung ein Bias-Potential angelegt ist und dessen gesteuerte Strecke an einem Ende mit dem anderen Ende der gesteuerten Strecke des ersten Transistors (T1) verbunden ist und an dem anderen Ende ein Ausgangssignal (A) abgibt, und
einem ersten Widerstand (R1), der zwischen das andere Ende des zweiten Transistors (T2) und ein zweites Versorgungspotential geschaltet ist,
**gekennzeichnet durch**
eine erste Kapazitat (C1), die der Steuerleitung des ersten Transistors (T1) vorgeschaltet ist,
einen dritten Transistor (T3) vom anderen Leitungstyp, dessen Steuerleitung an dem anderen Ende der gesteuerten Strecke des zweiten Transistors (T2) und dessen gesteuerte Strecke an einem Ende mit dem zweiten Versorgungspotential (VP) verbunden ist,
einen vierten Transistor (T4) vom anderen Leitungstyp, dessen Steuerleitung mit dem anderen Ende der gesteuerten Strecke des dritten Transistors (T3) verbunden ist und dessen gesteuerte Strecke an einem Ende mit der Steuerleitung des dritten Transistors (T3) verbunden ist,
einen zweiten Widerstand (R2), der zwischen die Steuerleitung des vierten Transistors (T4) und einen Anschluß der ersten Kapazität (C1) geschaltet ist, und
einen dritten Widerstand (R3), der zwischen das andere Ende der gesteuerten Strecke des vierten Transistors (T4) und den anderen Anschluß der ersten Kapazität (C1) geschaltet ist.

2. Verstärkerschaltung nach Anspruch 1,
bei der die Steuerleitung des vierten Transistors (T4) über eine zweite Kapazität (C2) mit dem ersten Versorgungspotential (VN) gekoppelt ist.

3. Verstärkerschaltung nach Anspruch 1 oder 2,
bei der das andere Ende der gesteuerten Strecke des vierten Transistors (T4) über eine dritte Kapazität (C3) mit dem ersten Versorgungspotential (VM) gekoppelt ist.

4. Verstärkerschaltung nach einem der vorherigen Ansprüche,
bei der das Bias-Potential mittels zwischen die Steuerleitung und das andere Ende der gesteuerten Strecke des zweiten Transistors (T2) geschalteten vierten Widerstands (R4) erzeugt wird.

5. Verstärkerschaltung nach Anspruch 4,
bei der zwischen die Steuerleitung des zweiten Transistors (T2) und das erste Versorgungspotential (VM) eine fünfte Kapazität (C5) geschaltet ist.

6. Verstärkerschaltung nach einem der vorherigen Ansprüche,
bei der an den Knotenpunkt zwischen zweitem Widerstand (R2) und erster Kapazität (C1) über einen fünften Widerstand (R5) das erste oder zweite Versorgungspotential (VN, VP) anlegbar ist.

7. Verstärkerschaltung nach einem der vorherigen Ansprüche,
bei der ein sechster Widerstand (R6) über einen gesteuerten Schalter (T5, R7, R8) dem ersten Widerstand (R1) parallel schaltbar ist.

8. Verstärkerschaltung nach einem der vorherigen Ansprüche,
bei der die Transistoren (T1, T2, T3, T4) vom Bipolartyp sind, wobei das eine Ende der jeweiligen gesteuerten Strekke durch den Emitter, das andere Ende der jeweiligen gesteuerten Strecke durch den Kollektor und die Steuerleitung durch die Basis gebildet werden.

## Claims

1. Amplifier circuit having
a first transistor (T1) of one conduction type, into whose control line an input signal (E) is coupled and whose controlled path is connected to a first supply potential (VN) at one end,
a second transistor (T2) of one conduction type, to whose control line a bias potential is applied and whose controlled path is connected to the other end of the controlled path of the first transistor (T1) at one end and outputs an output signal (A) at the other end, and
a first resistor (R1), which is connected between the other end of the second transistor (T2) and a second supply potential,
characterized by
a first capacitor (C1), which is connected upstream of the control line of the first transistor (T1),
a third transistor (T3) of the other conduction type, whose control line is connected at the other end of the controlled path of the second transistor (T2) and whose controlled path is connected to the second supply potential (VP) at one end,
a fourth transistor (T4) of the other conduction type, whose control line is connected to the other end of the controlled path of the third transistor (T3) and whose controlled path is connected to the control line of the third transistor (T3) at one end,
a second resistor (R2), which is connected between the control line of the fourth transistor (T4) and one terminal of the first capacitor (C1), and
a third resistor (R3), which is connected between the other end of the controlled path of the fourth transistor (T4) and the other terminal of the first capacitor (C1).

2. Amplifier circuit according to Claim 1,
in which the control line of the fourth transistor (T4) is coupled to the first supply potential (VN) via a second capacitor (C2).

3. Amplifier circuit according to Claim 1 or 2,
in which the other end of the controlled path of the fourth transistor (T4) is coupled to the first supply potential (VM) via a third capacitor (C3).

4. Amplifier circuit according to one of the preceding claims,
in which the bias potential is generated by means of a fourth resistor (R4) connected between the control line and the other end of the controlled path of the second transistor (T2).

5. Amplifier circuit according to Claim 4,
in which a fifth capacitor (C5) is connected between the control line of the second transistor (T2) and the first supply potential (VM).

6. Amplifier circuit according to one of the preceding claims,
in which the first or second supply potential (VN, VP) can be applied to the node between the second resistor (R2) and first capacitor (C1) via a fifth resistor (R5).

7. Amplifier circuit according to one of the preceding claims,
in which a sixth resistor (R6) can be connected in parallel with the first resistor (R1) via a controlled switch (T5, R7, R8).

8. Amplifier circuit according to one of the preceding claims,
in which the transistors (T1, T2, T3, T4) are of the bipolar type, one end of the respective controlled path being formed by the emitter, the other end of the respective controlled path being formed by the collector and the control line being formed by the base.

## Revendications

1. Circuit amplificateur comportant
un premier transistor (T1) d'un type de conductivité, dans la ligne de commande duquel un signal (E) d'entrée est injecté et dont la section commandée est reliée en une extrémité à un premier potentiel (VN) d'alimentation,
un deuxième transistor (T2) d'un type de conductivité, à la ligne de commande duquel un potentiel de polarisation est appliqué et dont la section commandée est reliée en une extrémité à l'autre extrémité de la section commandée du premier transistor (T1) et fournit à l'autre extrémité un signal (A) de sortie, et
une première résistance (R1) qui est branchée entre l'autre extrémité du deuxième transistor (T2) et un deuxième potentiel d'alimentation,
caractérisé par
une première capacité (C1) qui est branchée en amont de la ligne de commande du premier transistor (T1),
un troisième transistor (T3) de l'autre type de conductivité, dont la ligne de commande est reliée en l'autre extrémité de la section commandée du deuxième transistor (T2) au deuxième potentiel (VP) d'alimentation et dont la section commandée est reliée en une extrémité au deuxième potentiel (VP) d'alimentation,
un quatrième transistor (T4) de l'autre type de conductivité, dont la ligne de commande est reliée à l'autre extrémité de la section commandée du troisième transistor (T3) et dont la section commandée est reliée en une extrémité à la ligne de commande du troisième transistor (T3),
une deuxième résistance (R2) qui est branchée entre la ligne de commande du quatrième transistor (T4) et une borne de la première capacité (C1), et
une troisième résistance (R3) qui est branchée entre l'autre extrémité de la section commandée du quatrième transistor (T4) et l'autre borne de la première capacité (C1).

2. Circuit amplificateur suivant la revendication, dans lequel la ligne de commande du quatrième transistor (T4) est couplée par l'intermédiaire d'une deuxième capacité (C2) au premier potentiel (VN) d'alimentation.

3. Circuit amplificateur suivant la revendication 1 ou 2, dans lequel l'autre extrémité de la section commandée du quatrième transistor (T4) est couplée par l'intermédiaire d'une troisième capacité (C3) au premier potentiel (VN) d'alimentation.

4. Circuit amplificateur suivant l'une des revendications précédentes, dans lequel le potentiel de polarisation est produit au moyen d'une quatrième résistance (R4) branchée entre la ligne de commande et l'autre extrémité de la section commandée du deuxième transistor (T2).

5. Circuit amplificateur suivant la revendication 4, dans lequel une cinquième capacité (C5) est branchée entre la ligne de commande du deuxième transistor (T2) et le premier potentiel (VN) d'alimentation.

6. Circuit amplificateur suivant l'une des revendications précédentes, dans lequel le premier potentiel (VN) d'alimentation ou le deuxième potentiel (VP) d'alimentation peut être appliqué au point nodal entre la deuxième résistance (R2) et la première capacité (C1) par l'intermédiaire d'une cinquième résistance (R5).

7. Circuit amplificateur suivant l'une des revendications précédentes, dans lequel une sixième résistance (R6) peut être branchée en parallèle à la première résistance (R1) par l'intermédiaire d'un commutateur (T5, R7, R8) commandé.

8. Circuit amplificateur suivant l'une des revendications précédentes, dans lequel les transistors (T1, T2, T3, T4) sont du type bipolaire, l'une des extrémités de la section commandée associée étant formée par l'émetteur, l'autre extrémité de la section commandée associée étant formée par le collecteur et la ligne de commande étant formée par la base.
